# EUROPEAN PATENT SPECIFICATION

(11) **EP 1 776 596 B1**
(45) Date of publication and mention of the grant of the patent: **16.09.2009**
(21) Application number: 05784826.9
(22) Date of filing: 21.07.2005
(51) Int. Cl.: G01R 31/3185

(54) **TESTING OF A CIRCUIT THAT HAS AN ASYNCHRONOUS TIMING CIRCUIT**
PRÜFUNG EINER SCHALTUNG MIT ASYNCHRONEM ZEITGEBER
TEST D'UN CIRCUIT PRESENTANT UN CIRCUIT DE SYNCHRONISATION ASYNCHRONE

(30) Priority: 03.08.2004 EP 04103731
(43) Date of publication of application: 25.04.2007
(73) Proprietor: Koninklijke Philips Electronics N.V., 5621 BA Eindhoven (NL)
(72) Inventor: PEETERS, Adrianus, M., G., NL-5656 AA Eindhoven (NL); TE BEEST, Frank, J., NL-5656 AA Eindhoven (NL)
(74) Representative: Bekkers, Joost J.J
(86) International application number: PCT/IB2005/052455
(87) International publication number: WO 2006/013524

(56) References cited:
- US-A- 4 698 588
- KHOCHE A ET AL: "A partial scan methodology for testing self-timed circuits" PROCEEDINGS 13TH IEEE VLSI TEST SYMPOSIUM (CAT. NO.95TH8068) IEEE COMPUT. SOC. PRESS LOS ALAMITOS, CA, USA, 1995, pages 283-289, XP002357634 ISBN: 0-8186-7000-2
- TE BEEST F ET AL: "Automatic scan insertion and test generation for asynchronous circuits" PROCEEDINGS INTERNATIONAL TEST CONFERENCE 2002. ITC 2002. BALTIMORE, MD, OCT. 7-10, 2002, INTERNATIONAL TEST CONFERENCE, NEW YORK, NY : IEEE, US, 7 October 2002 (2002-10-07), pages 804-813, XP010609811 ISBN: 0-7803-7542-4

## Description

The invention relates to testing of an asynchronously controlled circuit, to a test prepared circuit with an asynchronously timing circuit with provisions to perform testing and to a method of generating test patterns for such a circuit.

Testability is an essential property of large electronic circuits. Synchronously clocked circuits are conventionally made testable by means of scan chain technology. Synchronous circuits contain registers that periodically capture output data that is produced by combinatorial logic circuits on the basis of input data from these registers. Scan chain technology couples the registers of the circuit under test in a shift register structure (the "scan chain") during testing. The scan chain makes it possible to control the input signals of the combinatorial logic circuits with test signals and to capture the response of these combinatorial logic circuits to the test signals. The captured response is used to determine whether the circuit contains defects.

The application of scan chain technology to asynchronous circuits presents additional problems. An asynchronous circuit has a timing circuit that determines when respective registers (e.g. flip-flops or latches) that are connected to the combinatorial logic operate to capture data. The timing circuit of the asynchronous circuit typically contains many logic circuits connected in an application dependent structure to adapt the generation of a timing signal in response to dynamic conditions individually for different registers to which the timing signals are applied. During testing these adaptive timing signals generally have to be replaced by more rigid timing signals from a central clock. When this is done the combinatorial circuits between the registers can be tested in the same way as in the case of combinatorial circuits.

However, in the case of an asynchronous circuit the timing circuit should be tested as well. This circuit lends itself less readily to scan chain testing because it does not have the conventional register-combinatorial logic structure of the data circuit. One way of making the timing circuit amenable to scan chain testing is to make it look like a data circuit, by inserting master-slave latch pairs into the timing circuit for test purposes and to connect these latch pairs in the scan shift register structure. During normal operation the latches are made transparent to realize asynchronous operation, but during testing the latches operate as registers. Effectively, this gives the timing circuit the same type of register/combinatorial logic structure as the data circuit. In this way it is made possible to control signals in the timing circuit with test signals and to observe the response of combinatorial logic circuits in the timing circuit.

Although this technique in principle provides a solution to testing of the timing part of an asynchronous circuit, particular attention should be paid to time-continuous feedback loops in the timing circuit. Such loops are typically used to implement asynchronous state machines, which are designed to assume a series of successive states, with state transitions determined by predetermined signal configurations. A time-continuous feedback loop in a digital circuit has the effect that it introduces a dependence of the output signals on preceding input signal changes. This is undesirable for test purposes, because it prevents that there is a one to one relation between test input signals and output signals of correctly operating circuits. Previous transitory signal configurations (glitches) during the application of test signals may affect the output signals.

Conventionally it is prevented that this occurs during testing by ensuring that master-slave latch pairs from the scan shift register structure are inserted in each time-continuous feedback loop of the timing circuit. When the master-slave latch pairs are put in a non-transparent state during testing, the time-continuous feedback loops are broken up, which ensures that the output signals will not depend on previous transitory signal configurations. As a result predictable test responses are ensured.

However, the addition of latches in the timing circuit slows down the circuit. The delay introduced by the additional latches in the asynchronous timing circuit is entirely overhead, because these latches have no function during operation. This may be contrasted with the registers in the data part of the circuits, which are used both during testing and normal operation, so that they do not constitute overhead.

WO 02/101926 describes how testing of an asynchronous timing circuit can be realized with less overhead. A dynamic scan shift register is integrated with the feedback loops to minimize the overhead. According to this document the time-continuous feedback loops are broken up by using at least two tri-state output circuits in each feedback loop. During testing at least one of the tri-state outputs in each feedback loop is kept in a high impedance state to break up the feedback loop. Additional tri-state coupling drivers are added between nodes of successive feedback loops especially for testing, so that a dynamic shift register can be formed. During testing the dynamic shift register is used to shift test data in and out through the scan shift register.

This structure provides for all required test facilities (shift transport of test data, application of test data, capture of responses and prevention that a history of glitches affect the test results). In addition, since only tri-state outputs instead of latches have to be added, there is little increased time delay in the timing circuit. However, the use of dynamic shift registers decreases the reliability of the circuit. Conventional test equipment cannot handle this, so that special test equipment has to be designed to use such registers. Moreover, in modern IC technologies dynamic circuit operation is not very reliable, especially when a slow tester clock is used. This makes it unattractive to use this known technique.

Among others, it is an object of the invention to provide for testing of an asynchronous timing circuit using a static scan chain compatible structure to control and observe signals in circuits with a time-continuous feedback loop in the asynchronous timing circuit, without introducing excessive delay in the asynchronous timing circuit and without running the risk that test results depend on transitory signal configurations.

Among others, it is an object of the invention to provide for testing of an asynchronous timing circuit using a static scan chain compatible structure, with a minimum of additional registers in the scan chain.

Among others, it is an object of the invention to provide for a method of testing of an asynchronous timing circuit with a time-continuous feedback loop wherein a conventional test pattern generator that does not account for time-continuous feedback loops can be used.

A test prepared circuit according to the invention is set forth in Claim 1. According to the invention a time-continuous feedback loop is first broken up and then temporarily restored during testing, to capture data determined by the feedback loop. Before restoration of the time-continuous feedback a multiplexing circuit is used to apply loop test data to a feedback input of the time-continuous feedback loop. The multiplexing circuit restores the time-continuous feedback loop during testing after loop-external input signals of the loop, which are determined by test data, have stabilized. This prevents unpredictable history dependent output signals. Because this makes it possible to perform testing with a restored time-continuous feedback loop there is no need to include latches in the feedback loop, which means that static latches can be used in the scan shift register structure outside the loop to supply and capture test data without affecting the delay of the asynchronous timing circuit. Preferably, circuits to provide only a single additional multiplexing circuit in signal path of the feedback loop are provided and no registers such as latches or flip-flops that serve only for test purposes are included in signal path around the loop. This minimizes the loss of speed during normal operation.

It is noted that KHOCHE A ET AL: "A partial scan methodology for testing self-timed circuits" PROCEEDINGS 13TH IEEE VLSI TEST SYMPOSIUM (CAT. NO.95TH8068) IEEE COMPUT. SOC. PRESS LOS ALAMITOS, CA, USA, 1995, pages 283-289, ISBN: 0-8186-7000-2, discloses a scan path for a circuit with asynchronously controlled timing comprising a multiplexing circuit in the feedback path replacing the feedback signal by a test signal from a register in the shift register structure. According to par. 5.2.2 of D 1 an OR-gate is introduced in the feedback line. This has the disadvantage as described in the same paragraph that only a 1 value can be controlled on the feedback line. The prior art referred to in D1 indeed uses a multiplexer in the feedback line, however in such a configuration that this leaves the normal feedback input to the multiplexer untested (par. 5.2.2 D1).

In an embodiment the asynchronous timing circuit comprises a plurality of interconnected time-continuous feedback loops ("interconnected" as used herein includes time-continuous coupling of signals from one time-continuous feedback loop to another and/or incorporation of at least part of one time-continuous feedback loop in another time-continuous feedback loop). In this case, signal development after restoration of one time-continuous feedback loop could affect the input signals of another time-continuous feedback loop, giving rise to unpredictable output signals. To prevent this, according to the invention, a test control circuit restores the time-continuous feedback loops only in a predetermined combination of feedback loops at a time, keeping the feedback loops outside the combination broken up. Several different combinations of feedback loops may be used, the feedback loops in each being restored separately. The feedback loops in a combination are selected so that no signal from any feedback loop in the combination affects the input signals of any other feedback loop in the combination, when the feedback loops outside de combination remain broken up. A minimum number of combinations that is required for this are two combinations, which together include all feedback loops of the asynchronous timing circuit. A worst-case situation would require a separate combination for each feedback loop, but it has been found that typically some five to seven different combinations suffice to include all feedback loops.

Preferably, a test result from the feedback loop is captured directly into a latch in the test scan shift register structure while the time-continuous feedback loop is restored. This minimizes complexity. Alternatively, of course a latch outside the test scan shift register structure may be used, the result being transferred into the shift register later. In both cases, the latch may be located outside feedback path of the time-continuous feedback loop, minimizing the additional delay. Preferably, the capturing latch has an input coupled directly to an output of the multiplexing structure (i.e. to an output at which the output signal depends in a one to one way on the signal at the selected input of the multiplexing circuit). In this way, the test data producing latch and the capturing latch can be readily combined into a register that is part of the shift register structure, to perform the function of shifting test data.

In an embodiment the capture latch is part of a data register that is used to supply and/or receive latched data (as opposed to timing signals) during normal operation. In this way a minimum of additional latches is needed for test purposes. Preferably, a multiplexer is added in front of this data register to switch between a test mode wherein a test result is captured from the restored time-continuous feedback loop, and another mode or modes wherein data is captured from the circuit. This preserves maximum testability.

Because the circuit according to the invention tests a time-continuous feedback loop, problems may arise when conventional test pattern generation software is used. This kind of software is designed to select patterns so that defects at all nodes of the circuit will show up, for which the circuit design of the circuit under test must be analysed, usually assuming that there are no feedback loops. Such software may be used nevertheless if it is presented with a modified circuit design, which does not correspond to the actual circuit design of the circuit under test, in the sense that in the modified design the input of the multiplexing structure that comes from the shift register structure is coupled to the input of the feedback loop that is coupled to the output of the multiplexing structure in the real design. Of course, such a modified design would not function properly during normal operation, but during test it would produce the same output signals as the actual circuit. This means that the test patterns generated for this modified circuit can be used to test the real circuit.

These and other objects and advantageous aspects of the invention will be described in more detail using non-limiting examples by reference to the following figures.
Figure 1 illustrates a circuit organization
Figure 1a illustrates a register cell
Figure 2 shows a typical component of an asynchronous timing circuit
Figure 3 shows a test-prepared component of an asynchronous timing circuit
Figure 3a,b show alternative test prepared components
Figure 4 shows a test-prepared component of an asynchronous timing circuit
Figure 5 shows a test-prepared component of an asynchronous timing circuit
Figure 6 shows part of a test-prepared asynchronous timing circuit
Figure 7 shows an example of signal pulses in a test circuit
Figure 8 shows a circuit for generating different test enable signals
Figure 9 shows a test environment

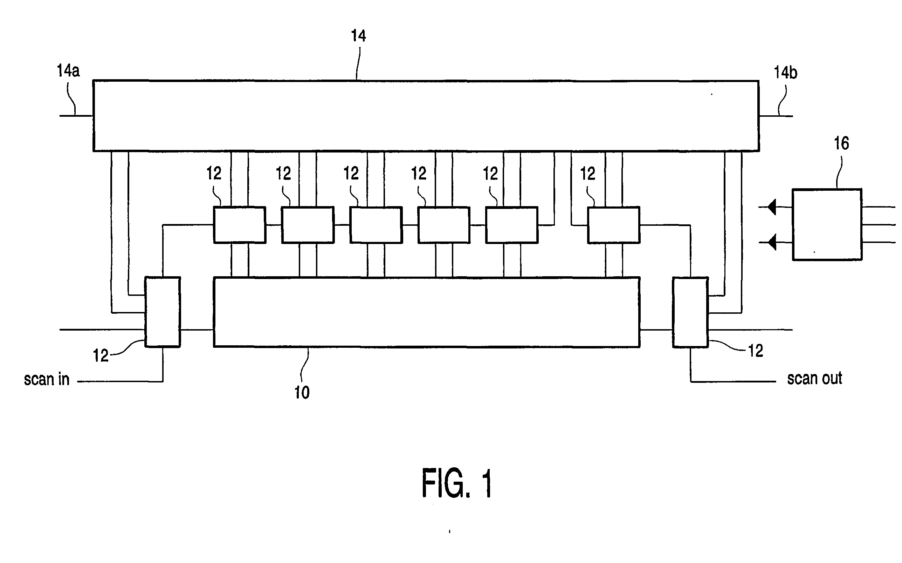

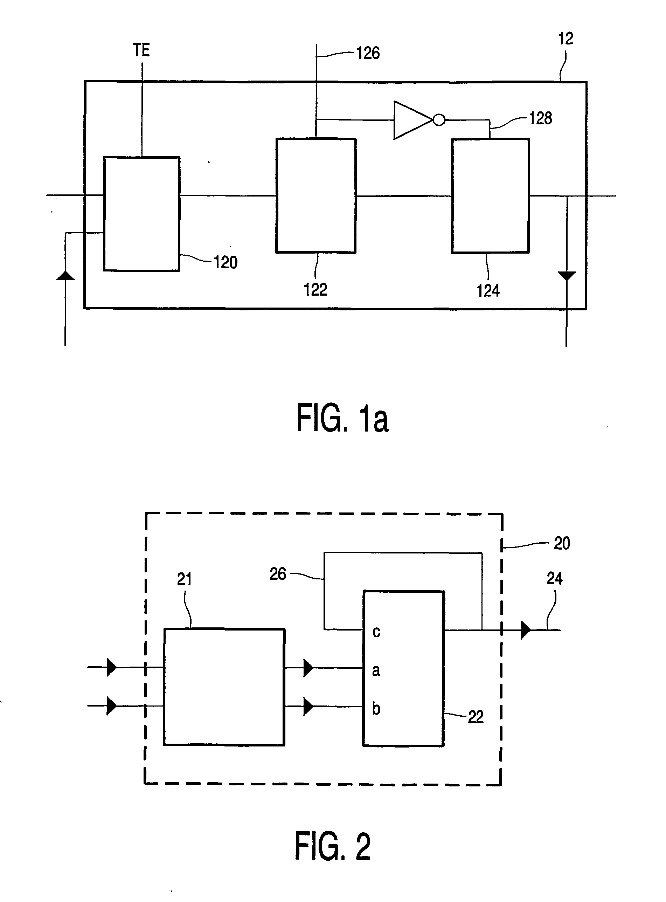

Figure 1 illustrates an organization of a typical digital circuit. The circuit contains combinatorial logic circuitry 10, registers 12, a timing circuit 14 and a test control circuit 16. Timing circuit 14 has an input interface 14a and an output interface 14b and outputs coupled to the registers 12. Inputs and outputs of the combinatorial logic circuitry 10 are coupled to the registers 12. Some of the registers 12 also have inputs or outputs coupled to external terminals. Furthermore, registers 12 are connected in series with each other and part of timing circuit 14 in a scan shift register structure. Test control circuit 16 has control outputs coupled to registers 12 and timing circuit 14 (coupling not shown explicitly).

In operation combinatorial logic circuitry 10 uses digital input signals to form digital output signals. The input signals are supplied from outputs of registers 12 to combinatorial logic circuitry 10 and the output signals from combinatorial logic circuitry 10 are received at inputs of registers 12. At points of time controlled by timing circuit 14 the output signals are copied into registers 12, after which the output signals are supplied as new input signals to combinatorial logic circuitry 10.

Although combinatorial logic circuitry 10 is shown as a single box, it should be understood that this box might stand for a collection of many such separate logic circuits. Similarly, although registers 12 are shown in a row, it should be understood in normal operation respective ones of the registers function as registers between successive logic circuits. The presentation of the figure with one box of combinatorial circuits and a row of registers has merely been chosen for explanatory purposes, not to represent the operational function.

The circuit of figure 1 is designed to support a test mode. In the test mode, test control circuit 16 sends control signals to registers 12 to function as a shift register, so that test input and output data can be shifted into and out of the circuit through the chain. Moreover, when the test input data is at a selected position in the chain, test control circuit 16 can control registers 12 to capture the output signals that combinatorial logic circuitry 10 produce in response to test input data from combinatorial logic circuitry 10.

Figure 1a shows a conventional embodiment of a register 12 for use in the circuit of figure 1. The register contains a multiplexer 120, and a first and second latch 122, 124. An input of the register for a signal from combinatorial logic circuitry 10 (not shown) is coupled to a first input of multiplexer 120, which has an output coupled to a data input of first latch 122. First latch 122 has an output coupled to second latch 124, which in turn has an output coupled to combinatorial logic circuitry 10 (not shown). A second input of multiplexer 120 is coupled to the output of a preceding register 12 (not shown) in the scan shift structure. During normal operation, test control circuit 16 controls multiplexer 120 to pass signals from combinatorial logic circuitry 10 (not shown). Timing signals at timing inputs of latches 122, 124 are used to capture data from a part of the combinatorial logic circuitry 10 and to pass captured data to other parts of the combinatorial logic circuitry 10.

In the test mode test control circuit 16 first controls multiplexer 120 to pass data from its second input, that is, from the output of a preceding register in the scan shift register structure. This allows test data to be shifted in. When the test data has reached a position from where it should be used by combinatorial logic circuitry 10, test control circuit 16 sets multiplexer 120 to pass data from combinatorial logic circuitry 10. This enables first latch 122 to capture a response to test input data from combinatorial logic circuitry 10. Combinatorial logic circuitry 10 forms this response by applying logic operations to test data from any one of the registers 12. The circuitry is said to be combinatorial because its output signals, once stabilized do not depend on previous transitory signal configurations. After the response has been captured test control circuit 16 controls multiplexer 120 to pass data from its second input, so that the test results can be shifted out.

The circuit of figure 1 is an asynchronous circuit, which means that timing circuit 14 has the capability to adapt the time differences between the points of time at which timing circuit 14 makes different registers 12 capture output signals from combinatorial logic circuits 10, dependent for example on timing signals received from input interface 14a or output interface 14b and/or on internal delays.

An asynchronous timing circuit 14 differs from a synchronous timing circuit. In a synchronous timing circuit the points of time at which registers capture data are defined by a central clock, which has a clock frequency that ensures sufficient delay between successive capture operations. In an asynchronous circuit the points of time are selected as a result of logic operations on timing signals from different sources, as well as transitory state information that is stored in the timing circuit. Many different forms of asynchronous timing circuits for this purpose are known per se. During testing, the selection of points of time is typically performed using a test clock. For this purpose multiplexers (not shown) are typically added at the timing control inputs of registers 12, to replace asynchronous timing signals by test clock signals. This addresses testing of combinatorial logic circuitry 10. However, the internal components in timing circuit 14 should preferably be tested as well.

Figure 2 shows a typical structure of a component 20 of an asynchronous timing circuit 14. The component contains a first combinatorial logic circuit 21 that is used in feed forward fashion and a second combinatorial logic circuit 22 of which an output 24 has a feedback connection 26 to one of its inputs. The inputs of first combinatorial circuit 21 typically derive from the output of components (not shown) that have a similar structure as the component 20. In this example first combinatorial logic circuit 21 has two inputs and two outputs and second combinatorial circuit 22 has three inputs a, b, c, (one of which serves as feedback input) and one output, but of course in other examples other numbers of inputs and outputs may occur.

The combination of second combinatorial circuit 22 and its feedback 26 is called a C-element. The logic function of the second combinatorial logic circuit 22 is designed so that the feedback can be used to lock the C-element into a state that depends on previous input signal values. The values of the input signals (a, b) of second combinatorial logic circuit 22 may be distinguished into different categories: set signal values, reset signal values and retention signal values. When the input signals (a, b) assumes a set value this causes the signal at output 24 to assume a first value. When the input signals (a, b) assume a reset value this causes the signal at the output 24 to assume a second value. When the input signals (a, b) assume a retention value this causes the signal at the output 24 to retain its previous value, whatever that value may be.

In a simple example, the second combinatorial circuit 22 may contain a latch comprised of a first and second NAND gate (not shown), the first NAND gate having a first input coupled to the c-input of second combinatorial circuit 22, and an output coupled to a first input of the second NAND gate, which has an output coupled to the output 24 of second combinatorial circuit 22. In this case inputs a, b of second combinatorial circuit 22 may be coupled to second inputs of the NAND gates respectively. In practice, however, second combinatorial circuit 22 will usually involve more complicated logic functions of its inputs.

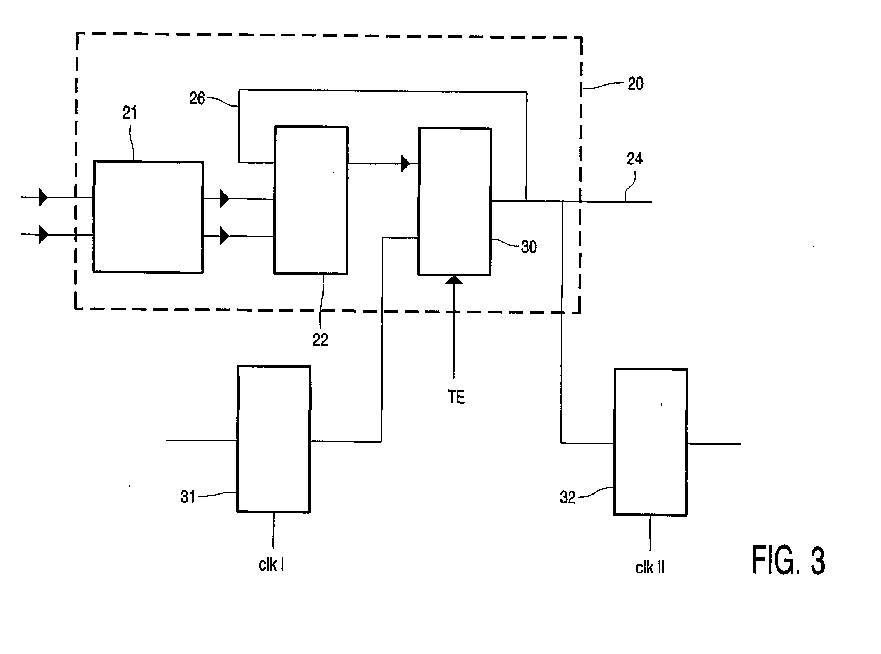

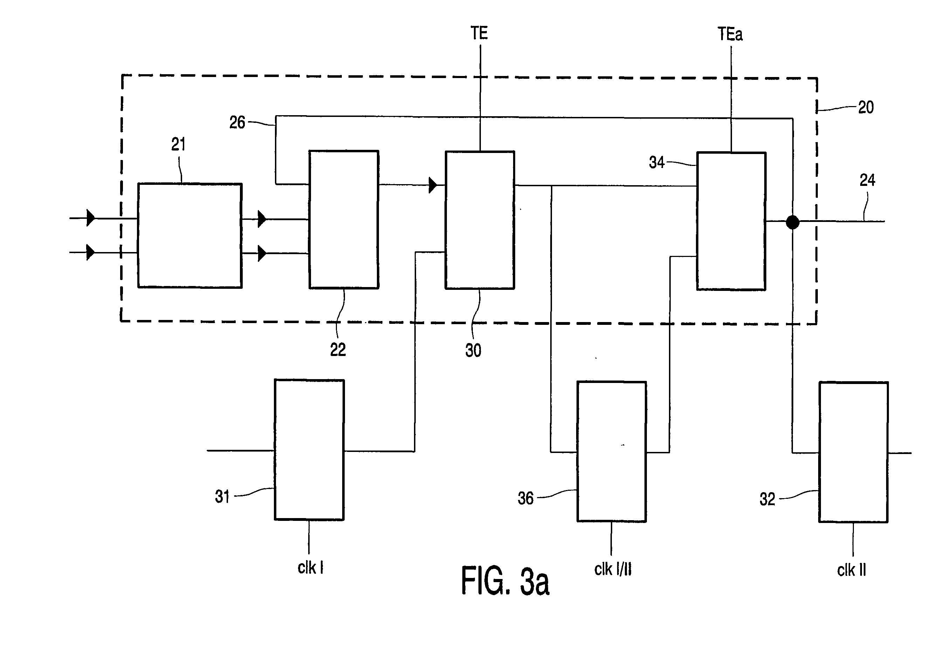

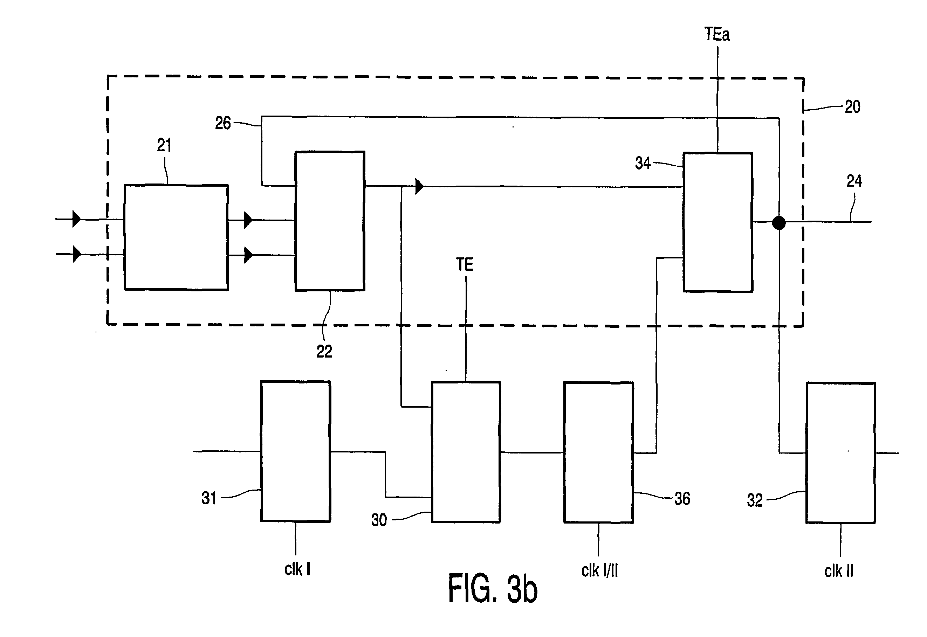

Figure 3 shows a modified version of the component 20 of figure 2, which has been modified to support testing. A multiplexer 30 has been added at the output of second combinatorial logic circuit 22. In addition to component 20 a first and second register 31, 32 that form part of the scan shift register structure are shown. Multiplexer 30 has a first input coupled to an output of second combinatorial logic circuit 22, a second input coupled to an output of the first register 31, an output coupled to output 24 and feedback 26 and a control input TE coupled to test control circuit 16 (not shown).

In operation, in the normal operation mode (when the circuit is not tested) test control circuit 16 (not shown) controls multiplexer 30 to pass the signals from its first input to its output. As a result, component 20 functions in the same way as the circuit of figure 2, with a slightly increased delay due to the added multiplexer 30.

In the test mode test input data is first shifted in via the scan shift register structure. During this shift phase, test control circuit 16 (not shown) sets the control signal TE at the control input of multiplexer 30 so that multiplexer 30 passes the signal from first register 31 to the output of multiplexer 30. In this way only multiplexer 30 is functionally inserted in the scan shift register structure.

Subsequently, component 20 is tested. Initially test control circuit 16 (not shown) keeps the control signal TE at a value so that multiplexer 30 passes the signal from first register 31 to the output of multiplexer 30. That is, the feedback loop is initially kept broken up. Test input signals are applied to component 20, via other components (not shown) of the timing circuit to the inputs of first combinatorial circuit 21. Because multiplexer 30 keeps the feedback loop broken up at this stage the output signal of second combinatorial logic circuit 22 does not depend on transitory previous signal configurations at its inputs.

Next, once the input signals of second combinatorial logic circuit 22 have stabilized, test control circuit 16 changes the control signal TE so that multiplexer 30 passes the signal from its first input, that is, from the output of second combinatorial circuit 22. In this way, the feedback loop is restored. If signals a,b have a set or reset value, the signal at the output of second combinatorial circuit 22 will retain the set or reset value respectively and the output signal of multiplexer 30 will assume this value. If signals a, b do not have the set or reset value, the signal at the output of second combinatorial circuit 22 will retain its previous value, i.e. the value previously defined by the signal at the second input of multiplexer 30. Hence, the output signal of multiplexer 30 will also retain its previous value. During this phase wherein the feedback loop is restored in the test procedure, a clock level change at second register 32 causes the output signal of multiplexer 30 to be captured in second register 32.

Subsequently test control circuit 16 sets the control signal TE of multiplexer 30 so that multiplexer 30 passes the signal from its second input to its output. This restores the scan shift register structure to its shift register function. Now the test output data is shifted through the scan shift register structure.

Although switching of multiplexer 30 to pass signals from its first input temporarily creates a feedback loop, this loop does not result in any dependence on unpredictable transitory signal configurations (provided that the circuit functions properly). This is because multiplexer 30 continues to supply a signal from first register 31, keeping the feedback loop broken until the other input of second combinatorial logic circuit have stabilized. The resulting output signal of second combinatorial logic circuit 22 may be a function of a retained previously applied input signal from first register 31, or a function of its other input signals, can be captured in second register 32 without timing risks.

The differences with the use of the circuit of figure 1a should be noted. First of all, of course, the circuit of figure 3 concerns part of the timing circuit 14, whereas the circuit of figure 1a is used for capturing test output data from the combinatorial logic circuit 10 that is used for data. Moreover, the circuit of figure 1 a is applied to feed forward circuits only, these circuits do not contain feedback paths in conventional scan test practice. In contrast, in figure 3 the component under test contains a feedback loop that results in retention of state information. However, in the particular case of C-elements this does not lead to any problems, because the feedback is broken until all its input signals but its feedback signal have stabilized.

In certain embodiments of timing circuit 14 some of the feedback loops may have negative loop gain, which occurs when there is an uneven number of inversions around these loops. Typically such feedback loops are interlaced with other feedback loops to ensure that these loops stabilize during normal use. However, if during testing such a feedback loop with negative loop gain would be restored on its own, while the stabilizing loops remain broken, this may prevent the restored feedback loop from stabilizing to a definite state. In such a timing circuit additional test circuitry is preferably provided for specifically for loops with negative loop gain to make it possible to test these feedback loops without restoring the loop.

Figure 3a shows how selected components with negative loop gain can be modified for this purpose. An additional multiplexer 34 is added in the loop, with a first input coupled to the output of the original multiplexer 30 and an output coupled to output 24 and feedback connection 26. An additional register 36 (typically made up of a pair of latches that are made alternatively transparent) has an input coupled to the output of the original multiplexer 30 and an output coupled to a second input of the additional multiplexer 34. The control input TE2 of additional multiplexer 34 receives a further test control signal TE2 from the test control circuit (not shown).

In normal operation both multiplexers 30, 34 control circuit 16 (not shown) controls the control signals TE, TE2 of the multiplexers so that the feedback loop is continuously closed. During test shift operation multiplexers 30, 34 control circuit 16 (not shown) controls the control signals TE, TE2 of the multiplexers so that registers 31, 32, 36 perform as part of the scan shift register structure (optionally, when testing of the loop is not needed, register 36 may be removed from the shift register in the shift mode by proper switching of the multiplexers 30, 34; this reduces the time needed for shifting).

Two test operation modes are used. In a first test mode test control circuit 16 (not shown) controls the control signals TE, TE2 of the multiplexers so that the original multiplexer 30 couples the output of second combinatorial circuit 22 to the output of original multiplexer 30 and additional multiplexer 34 couples the output of additional register 36 to the output of additional multiplexer 34. Thus, the loop remains broken, test input data from additional register 36 is supplied to second combinatorial logic circuit 22 and a result is captured in additional register 36 (the output of additional register 36 is also captured in register 32). In a second test mode control circuit 16 (not shown) controls the control signals TE, TE2 of the multiplexers so that the original multiplexer 30 couples the output of register 31 to the output of original multiplexer 30 and additional multiplexer 34 couples the output of original multiplexer 30 to the output of additional multiplexer 34. Thus, the loop also remains broken, now test input data from register 31 is supplied to output 24 where it is captured by the second combinatorial logic circuit 22 and a result is captured in additional register 32 (and the output of register 31 is also captured in additional register 36).

It should be noted that this method of testing requires two multiplexers 30, 34 in the loop, which reduces the speed of normal operation. As is shown in figure 3b, one of the multiplexers could be removed from the loop by coupling the output of second combinatorial circuit 22 directly to the second input of additional multiplexer 34. This makes it possible to perform testing without closing the loop, supplying test data from additional register 36 and capturing test results in additional register 36. However, in this case it is impossible to test the part of the loop between second combinatorial circuit 22 and additional multiplexer 36. Therefore, it can be seen that to support full testability more multiplexers have to be inserted than in the case of a feedback loop with positive feedback (cf. figure 3) where the feedback loop can be restored as part of testing.

It will be appreciated that it is not necessary in this embodiment that the multiplexers 30, 34 are in series: they may be included anywhere along the loop, so that logic circuits are operational between the multiplexers in normal operation. Furthermore, it should be appreciated that the use of two multiplexers is not always necessary in this case. If the loop with negative loop gain can be stabilized in another way, e.g. by restoring other related loops, this may be used to test such a loop.

First and second register 31, 32 may be registers that are included in the scan shift register structure for no other purpose than supplying test input data to component 20 and capturing a response data from component 20. However, in a further embodiment one or more registers may be used from a register 12 that is also used to capture data from combinatorial circuitry 10.

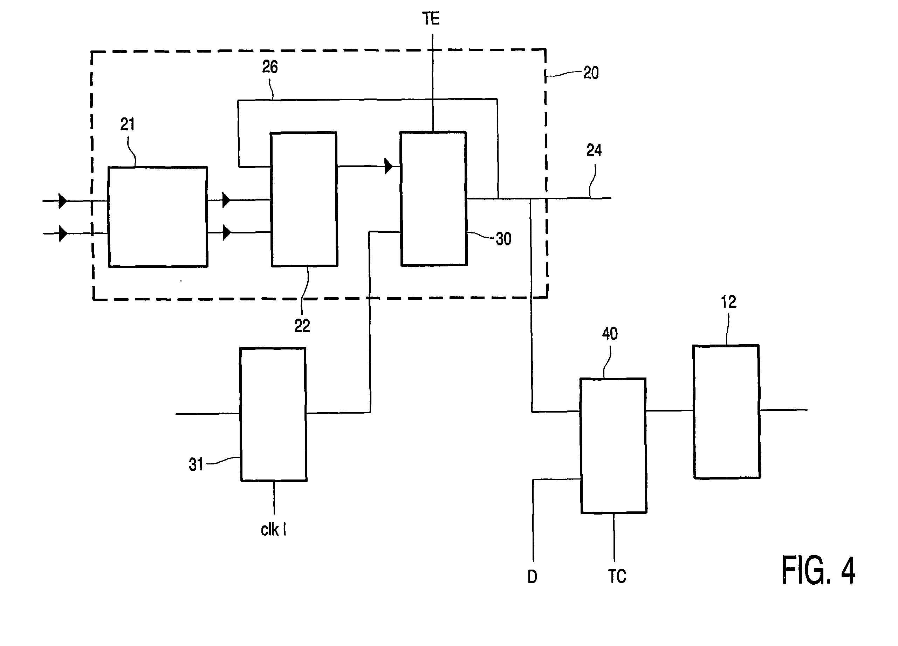

Figure 4 shows an embodiment of a circuit that uses a register 12 to capture test results from both combinatorial circuitry 10 (Not shown in Figure 4) and from component 20. To make this possible a further multiplexer 40 has been added. Further multiplexer has a first input coupled to the output of multiplexer 30 and a second input coupled to the output of combinatorial logic circuitry 10 that is normally coupled to the input of register 12. An output of further multiplexer 40 is coupled to the input of register 12. A control input TC of further multiplexer 40 is coupled to test control circuit 16 (not shown). In operation, in the test mode, test control circuit 16 has the option of applying a control circuit that causes test response data to be captured from component 20 instead of from combinatorial logic circuitry. In the normal mode register 12 has no function in timing circuit 14, in this mode it functions as data register, operating in cooperation with combinatorial logic circuitry 10.

Although the invention has been illustrated by means of specific circuit embodiments it should be realized that the invention is not limited to these embodiments. For example, a strict separation between the combinatorial logic circuits 10 and timing circuit 14 has been shown. This separation applies for example to pipelined circuits, wherein data is logically processed in steps and the data is stored between the steps, at least when predecessor data is processed in a next step. However, the invention is not limited to such a strict separation. In other examples the timing circuit may receive input signals from the combinatorial circuits, for example to introduce data value dependent delays, or to generate timing signals in response to the arrival of a data signal. Furthermore, timing circuit may use interactive signal exchanges, such as handshakes wherein timing circuit 14 sends or receives request or acknowledge signals.

Furthermore, although for the sake of simplicity a single shift register structure has been shown, it should be realized that more complicated structures, containing more shift registers, or shift registers with branching or converging shift paths may of course be used. Also, where the use of multiplexers has been described it should be understood that these multiplexers could be implemented with any circuit that has a multiplex function. This includes a logic circuit with an input output relation that copies data from one data input or another dependent on the value of a control signal on a control data input, a circuit with control signal controlled switches between the output and respective inputs, or tri-state drivers with outputs coupled to a multiplexer output and inputs coupled to the respective inputs, the control signal determining which of the drivers will not be in a high impedance output state.

In each case, the multiplexer function may be integrated with the combinatorial logic circuits that precede the multiplexer, e.g. by using tri-state stages in the final stage of the preceding combinatorial logic circuit, or by integrating the input output relation of the combinatorial logic circuit with the input output relation that corresponds to multiplexing.

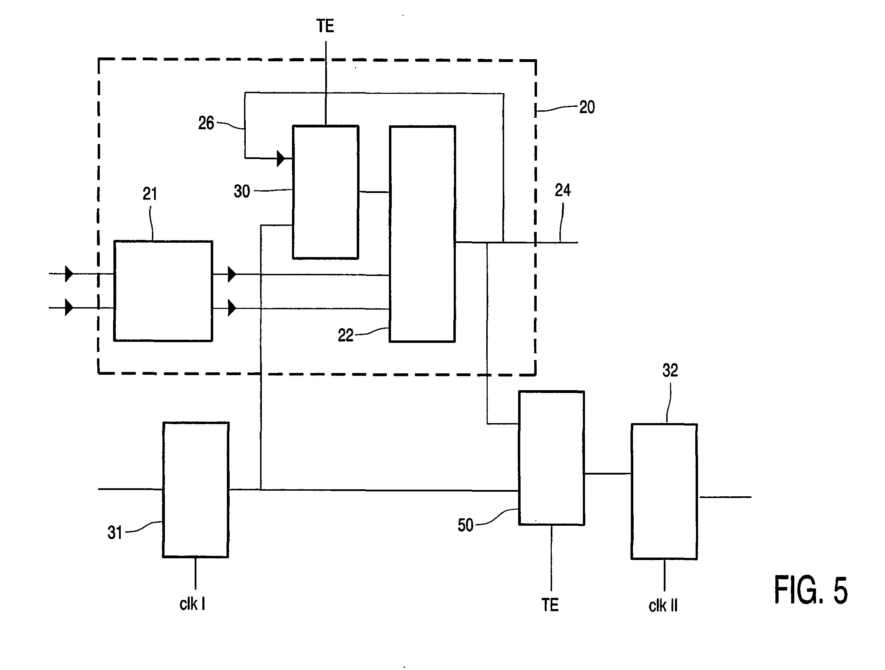

Furthermore, although an embodiment has been shown wherein the multiplexer is coupled between the output of second combinatorial logic circuit 22 on one hand and the output of component 20 and the feedback connection on the other hand, it should be appreciated that the multiplexer may be located elsewhere in the feedback loop. Figure 5 shows an example wherein multiplexer 30 is located in the feedback connection, but outside the connection between the output of second combinatorial logic circuit 22 and the output of component 20. For illustration purposes an additional multiplexer 50 has been added in the scan shift register structure to ensure that test data can be shifted from first register 31 to second register 32 in shift mode or test result data can be captured during testing. Additional multiplexer 50 may be omitted if the input of second register 32 is coupled to the output of multiplexer 30 or a signal line that carries a signal that is one to one dependent on this output. Whether this is possible depends on whether the output signal of the component is sufficiently observable.

Alternatively the multiplexer may be located inside second combinatorial logic circuit 22, provided that it breaks up the feedback loop. In each case this makes it possible to support (a) normal operation wherein the feedback loop operates continuously, (b) shift operation wherein the feedback loop is broken and test data can be shifted through the scan test register structure, (c) feeding of test data into the loop until the other inputs have stabilized, (d) subsequent reestablishment of the feedback loop and (e) capturing test result data while the feedback loop is temporarily restored during testing.

A problem may occur when output 24 is coupled to an input of a feedback loop of another component 20. This is because the signal at output 24 may change once the feedback loop is re-established. If the feedback loop in the other component is re-established at the same time this may have the effect that the input signals of the other component change after reestablishment of its feedback loop, with the risk that transitory signals affect the output.

One solution would be to add an additional circuit (e.g. a further multiplexer not shown) to disable that, during the test, signal development at the output 24 affects further feedback loops down stream (not shown). However, such an additional circuit may slow down circuit operation. Therefore it is advantageous to avoid such additional circuits.

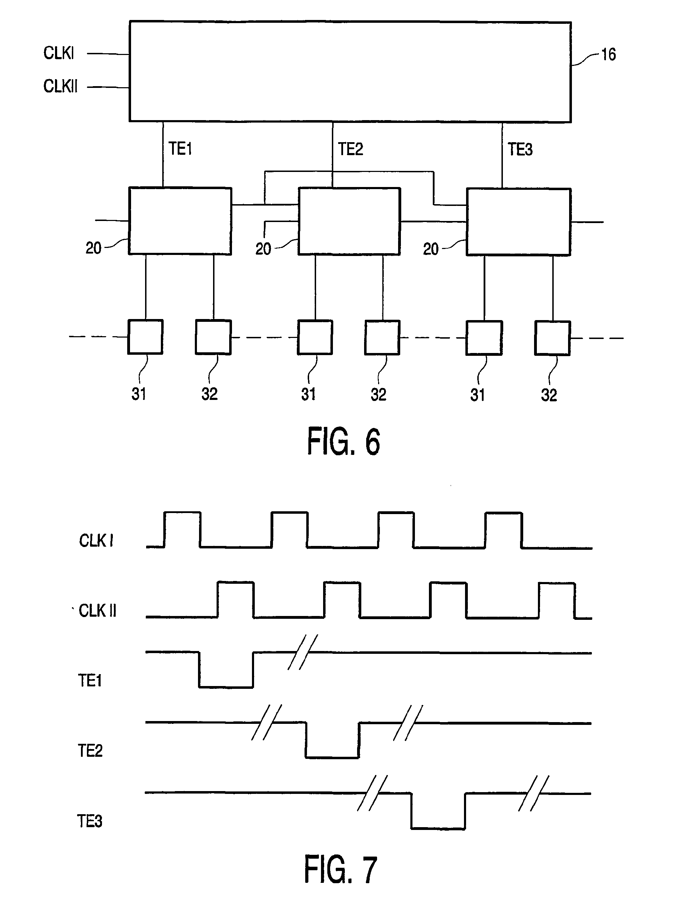

Figure 6 shows part of an asynchronous timing circuit containing a plurality of components 20, each including a multiplexer (not shown), the test control circuit 16 and part of the scan chain structure 31, 32. As shown, each component 20 is coupled to the scan shift register structure to receive test input data and to output test output data. Test control circuit 16 has different test enable outputs TE1, TE2 and TE3 coupled to respective ones of the components. Each test enable output TE1, TE2, TE3 may be coupled to a plurality of different components 20 (not shown). It should be appreciated that additional registers (not shown) may be included in the scan shift register structure, and that further connections (not shown) may be present to and from the components 20 to other components (not shown). Figure 7 shows an example of signal pulses on the test enable outputs TE1, TE2, TE3 and clock lines CLK I and CLK II. As shown, clock lines CLK I and CLK II have non overlapping pulses. During the pulses registers 31, 32 are transparent respectively and outside the pulses registers 31, 32 hold data. Each test enable signal TE1, TE2, TE3 contains negative pulses that re-establish feedback loops and start with a delay with respect to the start of a pulse of CLK I. This delay is arranged to have sufficient size to ensure that the non-feedback inputs of the feedback loop, which change upon a pulse in CLK I, have stabilized before multiplexer 30 re-establishes the feedback loop. The negative pulses in TE1, TE2, TE3 last at least until the end of pulses in the second clock CLK II when data from the feedback loop has been captured.

To prevent unpredictable test results different test enable signals TE1, TE2, TE3 are used that contain pulses to re-establish the feedback loops in mutually different clock period (possibly, but not necessarily in adjoining clock periods). In particular the test enable signal TE1, TE2, TE3 for a particular component 20 with a feedback loop contains a pulse only when the test enable signals TE1, TE2, TE3 for other components 20 with feedback loops that feed input signals to the particular component 20 do not contain a pulse.

In this way predictable test results can be realized without additional circuits need be included in the timing circuit. The number of different test enable signals TE1, TE2, TE3 that is needed for this depends on the structure of the timing circuit. Of course, it suffices in any case to use as many different timing circuits as there are components 20. However, usually it suffices to use fewer different test enable signals TE1, TE2, TE3, such as five or seven different test enable signals TE1, TE2, TE3. All that is needed is that each particular component 20 with a feedback loop has a test enable signal that contains a pulse only when the test enable signals TE1, TE2, TE3 for other components 20 with feedback loops that feed input signals to the particular component 20 do not contain a pulse. The same test enable signal TE1, TE2, TE3 may be supplied to a plurality of components that do not supply input signals to other components in the same plurality.

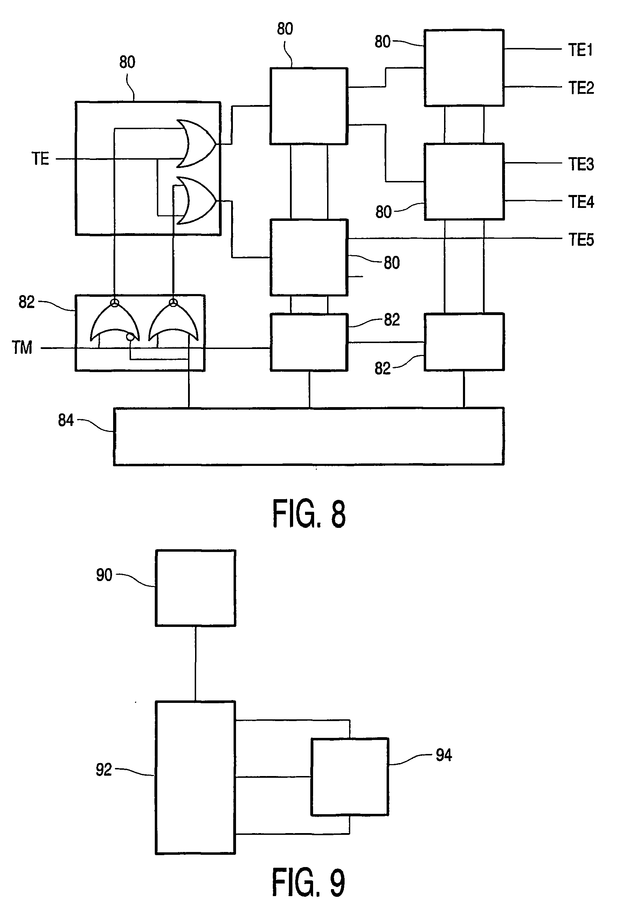

Figure 8 shows a circuit for generating different test enable signals. The circuit contains a selection generation circuit 84, decoders 80 and row elements 82. Circuit structure for one decoder 80 and row element 82 is shown in more detail. During normal (asynchronous) operation both inputs TE and TM of the circuit are logic zero, so that all selection outputs TE1-5 are zero, allowing components 20 to operate asynchronously with feedback loops. During testing inputs TE, TM are first made logic high to enable shifting. Now all TE1-5 are logic high. Next, during sampling, TE is made logic low while selection generation circuit 84 applies selection signals that encode the test enable signal that should produce an output pulse. As a result, decoders 80, which are coupled in a tree structure will lower the test enable signal on a selected output to re-establish a feedback loop. Later, TE is made logic high again and the signals that encode the test enable signal are changed before establishing another feedback loop. When the combinatorial logic circuitry 10 is tested none of the test enable signals are made logic low. The selection codes may be supplied to selection generation circuit 84 via part of the scan shift register structure for example.

Figure 9 shows a test environment containing a test pattern computation circuit 90, a test pattern application circuit 92 and a device under test 94. Device under test 94 contains the circuits shown in the preceding figures. Test pattern computation circuit 90 computes a set of test patterns for detecting all envisioned possible defects of the device under test 94 and transmits the computed test patterns to test pattern application circuit 92. Test pattern application circuit 92 sends signals to the devices under test 94 to switch to the appropriate test modes and supplies these test patterns to devices under test 94 that are connected successively (and/or in parallel) to test pattern application circuit 92.

Test pattern computation circuit 90 is for example a suitably programmed computer. The program uses a description of the circuits in device under test 94 to generate test patterns for detecting all envisioned defects. Programs for this purpose can be very complex, but are known per se in the art for testing combinatorial logic circuits that do not contain feedback loops.

Preferably, it is ensured that test patterns for circuits with feedback loops of the type shown in the figures can also be generated. In an embodiment this is realized by supplying a description of a virtual circuit to test pattern computation circuit 90. The virtual circuit may be obtained for example by means of a pre-processing program that modifies the circuit description under test before the computation of the test patterns. The virtual circuit equals the circuit of the device under test 94, except that according to the virtual circuit feedback connection 26 is coupled to the input of second combinatorial logic circuit 22 from the output of first register 31 instead of from the output of multiplexer 30. That is, in the virtual circuit there is no feedback in any state of multiplexer 30.

This makes it possible to generate test patterns using a program for generating test patterns for combinatorial logic circuits that do not contain feedback loops. If the device under test operates properly it will have the same output signals as predicted for the virtual circuit in the test mode. Therefore the test analysis can proceed as if the virtual circuit was tested. For this conventional test equipment can be used.

## Claims

1. A testable circuit with asynchronously controlled timing, the circuit comprising
- a test control circuit (16);
- a test scan shift register structure (12) comprising a register (31);
- an asynchronous timing circuit (14), comprising a time-continuous feedback loop (22, 26) and a multiplexing circuit (30), the feedback loop comprising a combinatorial logic circuit (22) with inputs for a feedback signal and a further signal, the multiplexing circuit (30) being switchable, under control of the test control circuit (16), between an operational mode wherein the multiplexing circuit (30) passes a time continuous signal along the feedback loop (22, 26) and a break mode wherein the multiplexing circuit (30) breaks the time-continuous feedback loop (22, 26), replacing the feedback signal by a test signal from the register (31) in the shift register structure, the test control circuit (16) being arranged to control that a further signal determined by a content of the shift register structure (12) is applied to the input for the further signal of the combinatorial logic circuit (22) in a test mode, initially keeping the multiplexing circuit (30) in the break mode until the further signal has stabilized and subsequently switching the multiplexing circuit (30) to the operational mode to restore the time-continuous feedback loop (22, 26) during the test mode, to capture a test result while the time-continuous feedback loop (20, 26) is restored,
**characterized in that** the test scan shift register structure comprises a further register (32) with an input coupled to the feedback loop (22, 26), the test control circuit (16) being arranged to cause the further register (32) to capture a test result determined by the feedback in the test mode while the multiplexing circuit (30) is in the operational mode and wherein the input of the further register (32) receives an output signal of the multiplexing circuit (30).

2. A testable circuit according to Claim 1, wherein the feedback loop has positive loop gain.

3. A testable circuit according to Claim 1, wherein the asynchronous timing circuit comprises a plurality of interconnected time-continuous feedback loops (20), each comprising a multiplexing circuit (30) that is switchable, under control of the test control circuit, between an operational mode and a break mode wherein the multiplexing circuit (30) breaks the time-continuous feedback loop (20) in which the multiplexing circuit (30) is comprised, replacing the feedback signal by a respective test signal from a respective register (31) in the shift register structure, the test control circuit (16) being arranged to control that the multiplexing circuits (30) are switched to the operational mode during the test mode substantially simultaneously only for selected feedback loops (20) or combinations of feedback loops (20), a combination being composed so that no restored feedback loop from the at least one combination affects the further signal of any other time-continuous feedback loops from at least one combination when only the time-continuous feedback loops of at least one combination are restored.

4. A testable circuit according to Claim 3, wherein the test control circuit (16) has a plurality of test enable outputs (TE1, TE2, TE3), for applying respective test enable signals to the multiplexing circuits (30) of the respective feedback loops (20) or combinations of time continuous feedback loops (20).

5. A testable circuit according to Claim 1, comprising a logic data processing circuit that comprises combinatorial logic data circuitry (10) and data registers (12) coupled to the combinatorial logic circuit to supply and receive data during normal operation, the data registers (12) forming part of the test scan shift register structure, the further register (32) being part of one of the data registers (12), the shift register structure comprising a multiplexer (40) having inputs coupled to the time-continuous feedback loop (22, 26) and the combinatorial logic data circuitry (10) respectively and an output coupled to the input of the further register (32).

6. A testable circuit according to Claim 1, wherein the asynchronous timing circuit (14) comprises a further time-continuous feedback loop, the further feedback loop having negative loop gain, the further feedback loop comprising a first and second further multiplexing circuit (30, 34), which are switchable, under control of the test control circuit (16), between an operational mode wherein the further multiplexing circuits pass a time continuous signal along the further feedback loop and a test mode, the test control circuit (16) being arranged to provide alternative test sub-modes wherein the first and second further multiplexing circuit (30, 34) keep the further feedback loop broken up respectively.

7. A method of testing a testable circuit that contains an asynchronous timing circuit (14), wherein the asynchronous timing circuit (14) comprises a time-continuous feedback loop (22, 26) and a multiplexing circuit in the feedback loop, with a combinatorial logic circuit (22) with inputs for a feedback signal and a further signal, the testable circuit comprising a test scan shift register structure (12), the method comprising
- switching the testable circuit to a test mode;
- shifting in test data through the shift register structure (12) in the test mode;
- controlling the further signal dependent on test data from the shift register structure (12);
- breaking the time-continuous feedback loop (22, 26) in the test mode, substituting test data from a register (31) in the shift register structure (12) for a feedback signal, the test data substituting the feedback signal via the multiplexing circuit;
**characterized by**
- restoring the time-continuous feedback loop in the test mode after the further signal has stabilized;
- capturing a test result determined by the feedback loop from an output of the multiplexing circuit while the feedback loop is restored, for transport through the shift register structure (12).

8. A method of testing according to Claim 7, wherein the asynchronous timing circuit (14) comprises a plurality of interconnected time-continuous feedback loops (20), the method comprising
- breaking the plurality of time-continuous feedback loops in the test mode, substituting test data from respective registers (31) in the shift register structure (12) for feedback signals in the plurality of time-continuous feedback loops (20);
- restoring the time-continuous feedback loops (20) in the test mode selectively for a group from the plurality of time-continuous feedback loops (20), the group having been selected so that no time-continuous feedback loop from the group affects the further signal of any other the time-continuous feedback loop of the group when the time-continuous feedback loops outside the group remain broken.

9. A method of testing according to Claim 7, wherein the feedback loop has positive loop gain.

10. A method of testing according to Claim 7, the method comprising capturing the test result in a further register (32) that forms part of the shift register structure while the time-continuous feedback loop is restored.

11. A method of testing according to Claim 7, wherein the testable circuit comprises a logic data processing circuit that comprises combinatorial logic data circuitry (10) and data registers (12) coupled to the combinatorial logic circuitry (10) to supply and receive data during normal operation, the data registers (12) forming part of the test scan shift register structure, the method comprising
- capturing the test result in one of the data registers (12) while the time-continuous feedback loop is restored.

## Patentansprüche

1. Prüfbare Schaltung mit asynchron gesteuerter, zeitlicher Koordinierung, wobei die Schaltung umfasst:
- eine Prüfsteuerschaltung (16),
- eine Test-Scan-Schieberegisterstruktur (12) mit einem Register (31);
- eine asynchrone Zeitgeberschaltung (14) mit einer zeitkontinuierlichen Rückkopplungsschleife (22, 26) und einer Multiplexschaltung (30), wobei die Rückkopplungsschleife eine kombinatorische Logikschaltung (22) mit Eingängen für ein Rückkopplungssignal und ein weiteres Signal umfasst, wobei die Multiplexschaltung (30) unter Steuerung der Prüfsteuerschaltung (16) zwischen einem Betriebsmodus, in dem die Multiplexschaltung (30) ein zeitkontinuierliches Signal entlang der Rückkopplungsschleife (22, 26) durchlässt, und einem Unterbrechungsmodus, in dem die Multiplexschaltung (30) die zeitkontinuierliche Rückkopplungsschleife (22, 26) unterbricht, schaltbar ist, wobei das Rückkopplungssignal durch ein Prüfsignal aus dem Register (31) in der Schieberegisterstruktur ersetzt wird, wobei die Prüfsteuerschaltung (16) angeordnet ist, um die Steuerung so vorzunehmen, dass ein durch einen Inhalt der Schieberegisterstruktur (12) ermitteltes, weiteres Signal an den Eingang für das weitere Signal der kombinatorischen Logikschaltung (22) in einem Prüfmodus angelegt wird, wobei anfänglich die Multiplexschaltung (30) in dem Unterbrechungsmodus gehalten wird, bis sich das weitere Signal stabilisiert hat, und danach die Multiplexschaltung (30) zur Wiederherstellung der zeitkontinuierlichen Rückkopplungsschleife (22, 26) während des Prüfmodus in den Betriebsmodus geschaltet wird, um ein Prüfergebnis festzuhalten, während die zeitkontinuierliche Rückkopplungsschleife (20, 26) wiederhergestellt wird,
**dadurch gekennzeichnet, dass** die Test-Scan-Schieberegisterstruktur ein weiteres Register (32) mit einem an die Rückkopplungsschleife (22, 26) gekoppelten Eingang umfasst, wobei die Prüfsteuerschaltung (16) angeordnet ist, um zu bewirken, dass das weitere Register (32) ein Prüfergebnis festhält, welches durch die Rückkopplung in dem Prüfmodus ermittelt wird, während sich die Multiplexschaltung (30) in dem Betriebsmodus befindet, und wobei der Eingang des weiteren Registers (32) ein Ausgangssignal der Multiplexschaltung (30) empfängt.

2. Prüfbare Schaltung nach Anspruch 1, wobei die Rückkopplungsschleife eine positive Schleifenverstärkung aufweist.

3. Prüfbare Schaltung nach Anspruch 1, wobei die asynchrone Zeitgeberschaltung eine Mehrzahl von miteinander verbundenen, zeitkontinuierlichen Rückkopplungsschleifen (20) umfasst, wobei jede eine Multiplexschaltung (30) aufweist, die unter Steuerung der Prüfsteuerschaltung zwischen einem Betriebsmodus und einem Unterbrechungsmodus schaltbar ist, in dem die Multiplexschaltung (30) die zeitkontinuierliche Rückkopplungsschleife (20), in welcher die Multiplexschaltung (30) enthalten ist, unterbricht, wobei das Rückkopplungssignal durch ein jeweiliges Prüfsignal aus einem jeweiligen Register (31) in der Schieberegisterstruktur ersetzt wird, wobei die Prüfsteuerschaltung (16) angeordnet ist, um die Steuerung so vorzunehmen, dass die Multiplexschaltungen (30) während des Prüfmodus lediglich bei ausgewählten Rückkopplungsschleifen (20) oder Kombinationen von Rückkopplungsschleifen (20) im Wesentlichen gleichzeitig in den Betriebsmodus geschaltet werden, wobei eine Kombination so zusammengesetzt ist, dass keine wiederhergestellte Rückkopplungsschleife aus der mindestens einen Kombination das weitere Signal anderer zeitkontinuierlicher Rückkopplungsschleifen aus mindestens einer Kombination beeinflusst, wenn lediglich die zeitkontinuierlichen Rückkopplungsschleifen von mindestens einer Kombination wiederhergestellt werden.

4. Prüfbare Schaltung nach Anspruch 3, wobei die Prüfsteuerschaltung (16) eine Mehrzahl von Testfreigabeausgängen (TE1, TE2, TE3) aufweist, um den Multiplexschaltungen (30) der jeweiligen Rückkopplungsschleifen (20) oder Kombinationen von zeitkontinuierlichen Rückkopplungsschleifen (20) jeweilige Testfreigabesignale zuzuführen.

5. Prüfbare Schaltung nach Anspruch 1, mit einer Datenverarbeitungslogikschaltung, die eine kombinatorische Datenlogikschaltung (10) sowie Datenregister (12) umfasst, die an die kombinatorische Logikschaltung gekoppelt sind, um während des normalen Betriebs Daten zuzuführen und zu empfangen, wobei die Datenregister (12) einen Teil der Test-Scan-Schieberegisterstruktur bilden, wobei das weitere Register (32) ein Teil eines der Datenregister (12) ist, wobei die Schieberegisterstruktur einen Multiplexer (40) mit Eingängen, die jeweils an die zeitkontinuierliche Rückkopplungsschleife (22, 26) und die kombinatorische Datenlogikschaltung (10) gekoppelt sind, und Ausgängen, die an den Eingang des weiteren Registers (32) gekoppelt sind, umfasst.

6. Prüfbare Schaltung nach Anspruch 1, wobei die asynchrone Zeitgeberschaltung (14) eine weitere zeitkontinuierliche Rückkopplungsschleife umfasst, wobei die weitere Rückkopplungsschleife eine negative Schleifenverstärkung aufweist, wobei die weitere Rückkopplungsschleife eine erste und zweite weitere Multiplexschaltung (30, 34) umfasst, die unter Steuerung der Prüfsteuerschaltung (16) zwischen einem Betriebsmodus, in dem die weiteren Multiplexschaltungen ein zeitkontinuierliches Signal entlang der weiteren Rückkopplungsschleife durchlassen, und einem Prüfmodus schaltbar sind, wobei die Prüfsteuerschaltung (16) angeordnet ist, um alternative Prüf-Submoden vorzusehen, wobei die erste und zweite weitere Multiplexschaltung (30, 34) die weitere Rückkopplungsschleife jeweils unterbrochen halten.

7. Verfahren zum Prüfen einer prüfbaren Schaltung, die eine asynchrone Zeitgeberschaltung (14) enthält, wobei die asynchrone Zeitgeberschaltung (14) eine zeitkontinuierliche Rückkopplungsschleife (22, 26) und eine Multiplexschaltung in der Rückkopplungsschleife mit einer kombinatorischen Logikschaltung (22) mit Eingängen für ein Rückkopplungssignal und ein weiteres Signal umfasst, wobei die prüfbare Schaltung eine Test-Scan-Schieberegisterstruktur (12) umfasst, wobei das Verfahren die folgenden Schritte umfasst:
- Schalten der prüfbaren Schaltung in einen Prüfmodus;
- Einschieben von Prüfdaten durch die Schieberegisterstruktur (12) in dem Prüfmodus;
- Steuern des weiteren Signals in Abhängigkeit von Prüfdaten aus der Schieberegisterstruktur (12);
- Unterbrechen der zeitkontinuierlichen Rückkopplungsschleife (22, 26) in dem Prüfmodus, Ersetzen von Prüfdaten aus einem Register (31) in der Schieberegisterstruktur (12) durch ein Rückkopplungssignal, wobei die Prüfdaten das Rückkopplungssignal über die Multiplexschaltung ersetzen;
**gekennzeichnet durch**
- Wiederherstellen der zeitkontinuierlichen Rückkopplungsschleife in dem Prüfmodus nach Stabilisieren des weiteren Signals;
- Festhalten eines Prüfergebnisses, welches **durch** die Rückkopplungsschleife anhand einer Abgabe der Multiplexschaltung während der Wiederherstellung der Rückkopplungsschleife ermittelt wird, zur Übertragung **durch** die Schieberegisterstruktur (12).

8. Verfahren nach Anspruch 7, wobei die asynchrone Zeitgeberschaltung (14) eine Mehrzahl von miteinander verbundenen, zeitkontinuierlichen Rückkopplungsschleifen (20) umfasst, wobei das Verfahren die folgenden Schritte umfasst:
- Unterbrechen der Mehrzahl von zeitkontinuierlichen Rückkopplungsschleifen in dem Prüfmodus, Ersetzen von Prüfdaten aus jeweiligen Registern (31) in der Schieberegisterstruktur (12) durch Rückkopplungssignale in der Mehrzahl von zeitkontinuierlichen Rückkopplungsschleifen (20);
- Selektives Wiederherstellen der zeitkontinuierlichen Rückkopplungsschleifen (20) in dem Prüfmodus bei einer Gruppe aus der Mehrzahl von zeitkontinuierlichen Rückkopplungsschleifen (20), wobei die Gruppe so ausgewählt wurde, dass keine zeitkontinuierliche Rückkopplungsschleife aus der Gruppe das weitere Signal einer anderen zeitkontinuierlichen Rückkopplungsschleife der Gruppe beeinflusst, wenn die zeitkontinuierlichen Rückkopplungsschleifen außerhalb der Gruppe unterbrochen bleiben.

9. Verfahren zur Prüfung nach Anspruch 7, wobei die Rückkopplungsschleife eine positive Schleifenverstärkung aufweist.

10. Verfahren zur Prüfung nach Anspruch 7, wobei das Verfahren das Festhalten des Prüfergebnisses in einem weiteren Register (32) umfasst, welches einen Teil der Schieberegisterstruktur bildet, während die zeitkontinuierliche Rückkopplungsschleife wiederhergestellt wird.

11. Verfahren zur Prüfung nach Anspruch 7, wobei die prüfbare Schaltung eine Datenverarbeitungslogikschaltung umfasst, die eine kombinatorische Datenlogikschaltung (10) sowie Datenregister (12) umfasst, die an die kombinatorische Logikschaltung (10) gekoppelt sind, um während des normalen Betriebs Daten zuzuführen und zu empfangen, wobei die Datenregister (12) einen Teil der Test-Scan-Schieberegisterstruktur bilden, wobei das Verfahren den Schritt des
- Festhaltens des Prüfergebnisses in einem der Datenregister (12), während die zeitkontinuierliche Rückkopplungsschleife wiederhergestellt wird, umfasst.

## Revendications

1. Circuit testable avec une synchronisation à commande asynchrone. le circuit comprenant :
- un circuit de commande d'essai (16) ;
- une structure de registre à décalage de balayage d'essai (12) comprenant un registre (31) ;
- un circuit de synchronisation asynchrone (14) comprenant une boucle de rétroaction continue dans le temps (22, 26) et un circuit de multiplexage (30), la boucle de rétroaction comprenant un circuit logique combinatoire (22) avec des entrées pour un signal de rétroaction et un nouveau autre signal, le circuit de multiplexage (30) étant commutable, sous la commande du circuit de commande d'essai (16), entre un mode de fonctionnement dans lequel le circuit de multiplexage (30) passe un signal continu dans le temps le long de la boucle de rétroaction (22, 26) et un mode d'interruption dans lequel le circuit de multiplexage (30) interrompt la boucle de rétroaction continue dans le temps (22, 26), remplaçant le signal de rétroaction par un signal d'essai en provenance du registre (31) dans la structure de registre à décalage, le circuit de commande d'essai (16) étant agencé de manière à vérifier si un nouveau autre signal qui est déterminé par un contenu de la structure de registre à décalage (12) est appliqué à l'entrée pour le nouveau autre signal du circuit logique combinatoire (22) dans un mode d'essai, maintenant initialement le circuit de multiplexage (30) dans le mode d'interruption jusqu'à ce que le nouveau autre signal se soit stabilisé et commutant ensuite le circuit de multiplexage (30) au mode de fonctionnement pour reconstituer la boucle de rétroaction continue dans le temps (22, 26) pendant le mode d'essai pour saisir un résultat d'essai alors que la boucle de rétroaction continue dans le temps (20, 26) est reconstituée,
**caractérisé en ce que** la structure de registre à décalage de balayage d'essai comprend un nouveau autre registre (32) avec une entrée qui est couplée à la boucle de rétroaction (22, 26), le circuit de commande d'essai (16) étant agencé de manière à effectuer que le nouveau autre registre (32) saisit un résultat d'essai qui est déterminé par la rétroaction dans le mode d'essai alors que le circuit de multiplexage (30) se situe dans le mode de fonctionnement et dans lequel l'entrée du nouveau autre registre (32) reçoit un signal de sortie du circuit de multiplexage (30).

2. Circuit testable selon la revendication 1, dans lequel la boucle de rétroaction présente un gain de boucle positif.

3. Circuit testable selon la revendication 1, dans lequel le circuit de synchronisation asynchrone comprend une pluralité de boucles de rétroaction interconnectées continues dans le temps (20), chacune comprenant un circuit de multiplexage (30) qui est commutable, sous la commande du circuit de commande d'essai, entre un mode de fonctionnement et un mode d'interruption dans lequel le circuit de multiplexage (30) interrompt la boucle de rétroaction continue dans le temps (20) dans laquelle le circuit de multiplexage (30) est contenu, remplaçant le signal de rétroaction par un signal d'essai en provenance d'un registre respectif (31) dans la structure de registre à décalage, le circuit de commande d'essai (16) étant agencé de manière à vérifier si les circuits de multiplexage (30) sont commutés au mode de fonctionnement pendant le mode d'essai d'une manière sensiblement simultanée seulement pour les boucles de rétroaction sélectionnées (20) ou pour les combinaisons des boucles de rétroaction (20), une combinaison étant composée, de sorte que pas de boucle de rétroaction reconstituée à partir de l'au moins une combinaison n'affecte le nouveau autre signal ou n'importe quelles autres boucles de rétroaction continues dans le temps à partir d'au moins une combinaison lorsque seules les boucles de rétroaction continues dans le temps d'au moins une combinaison sont reconstituées.

4. Circuit testable selon la revendication 3, dans lequel le circuit de commande d'essai (16) présente une pluralité de sorties de validation d'essai (TE1, TE2, TE3) pour appliquer des signaux de validation d'essai respectifs aux circuits de multiplexage (30) des boucles de rétroaction respectives (20) ou aux combinaisons des boucles de rétroaction continues dans le temps (20).

5. Circuit testable selon la revendication 1, comprenant un circuit de traitement de données logiques qui comprend des circuits combinatoires de données logiques (10) et des registres de données (12) qui sont couplés au circuit logique combinatoire pour fournir et pour recevoir des données pendant le fonctionnement normal, les registres de données (12) faisant partie de la structure de registre à décalage de balayage d'essai, le nouveau autre registre (32) faisant partie d'un des registres de données (12), la structure de registre à décalage comprenant un multiplexeur (40) ayant des entrées qui sont couplées à la boucle de rétroaction continue dans le temps (22, 26) et aux circuits combinatoires de données logiques (10), respectivement, et une sortie qui est couplée à l'entrée du nouveau autre registre (32).

6. Circuit testable selon la revendication 1, dans lequel le circuit de synchronisation asynchrone (14) comprend une nouvelle autre boucle de rétroaction continue dans le temps, la nouvelle autre boucle de rétroaction ayant un gain de boucle négatif, la nouvelle autre boucle de rétroaction comprenant un premier et un deuxième nouveau autre circuit de multiplexage (30, 34) qui sont commutables, sous la commande du circuit de commande d'essai (16), entre un mode de fonctionnement dans lequel les nouveaux autres circuits de multiplexage passent un signal continu dans le temps le long de la nouvelle autre boucle de rétroaction et un mode d'essai, le circuit de commande d'essai (16) étant agencé de manière à fournir des sous-modes d'essai alternatifs dans lesquels le premier et le deuxième nouveau autre circuit de multiplexage (30, 34) maintiennent interrompue la nouvelle autre boucle de rétroaction, respectivement.

7. Procédé d'essai d'un circuit testable qui contient un circuit de synchronisation asynchrone (14), dans lequel le circuit de synchronisation asynchrone (14) comprend une boucle de rétroaction continue dans le temps (22, 26) et un circuit de multiplexage dans la boucle de rétroaction avec un circuit logique combinatoire (22) ayant des entrées pour un signal de rétroaction et pour un nouveau autre signal, le circuit testable comprenant une structure de registre à décalage de balayage d'essai (12), le procédé comprenant les étapes suivantes consistant à :
- commuter le circuit testable à un mode d'essai ;
- décaler les données d'essai par le biais de la structure de registre à décalage (12) dans le mode d'essai ;
- commander le nouveau autre signal en fonction des données d'essai en provenance de la structure de registre à décalage (12) ;
- interrompre la boucle de rétroaction continue dans le temps (22, 26) dans le mode d'essai, à substituer les données d'essai en provenance d'registre (31) dans la structure de registre à décalage (12) à un signal de rétroaction, les données d'essai substituant le signal de rétroaction par le biais d'un circuit de multiplexage ; **caractérisé par** les étapes suivantes consistant à :
- reconstituer la boucle de rétroaction continue dans le temps dans le mode d'essai après que le nouveau autre signal s'est stabilisé ;
- saisir un résultat d'essai qui est déterminé à partir d'une sortie du circuit de multiplexage alors que la boucle de rétroaction est reconstituée pour le transport par le biais de la structure de registre à décalage (12).

8. Procédé d'essai selon la revendication 7, dans lequel le circuit de synchronisation asynchrone (14) comprend une pluralité de boucles de rétroaction interconnectées continues dans le temps (20), le procédé comprenant les étapes suivantes consistant à :
- interrompre la pluralité de boucles de rétroaction continues dans le temps dans le mode d'essai, à substituer les données d'essai en provenance des registres respectifs (31) dans la structure de registre à décalage (12) à des signaux de rétroaction dans la pluralité de boucles de rétroaction continues dans le temps (20) ;
- reconstituer les boucles de rétroaction continues dans le temps (20) dans le mode d'essai sélectivement pour un groupe en provenance d'une pluralité de boucles de rétroaction continues dans le temps (20), le groupe ayant été sélectionné, de sorte que pas de boucle de rétroaction continue dans le temps en provenance du groupe n'affecte le nouveau autre signal de n'importe quelle autre boucle de rétroaction continue dans le temps du groupe lorsque les boucles de rétroaction continues dans le temps en dehors du groupe restent interrompues.

9. Procédé d'essai selon la revendication 7, dans lequel la boucle de rétroaction présente un gain de boucle positif.

10. Procédé d'essai selon la revendication 7, le procédé comprenant la saisie du résultat d'essai dans un nouveau autre registre (32) qui fait partie de la structure de registre à décalage alors que la boucle de rétroaction continue dans le temps est reconstituée.

11. Procédé d'essai selon la revendication 7, dans lequel le circuit testable comprend un circuit de traitement de données logiques qui comprend des circuits combinatoires de données logiques (10) et des registres de données (12) qui sont couplés aux circuits logiques combinatoires pour fournir et pour recevoir des données pendant le fonctionnement normal, les registres de données (12) faisant partie de la structure de registre à décalage de balayage d'essai, le procédé comprenant l'étape suivante consistant à :
- saisir le résultat d'essai dans un des registres de données (12) alors que la boucle de rétroaction continue dans le temps est reconstituée.
